# EUROPÄISCHE PATENTANMELDUNG

(11) **EP 1 315 213 A2**
(43) Veröffentlichungstag der Anmeldung: **28.05.2003**
(21) Anmeldenummer: 02023103.1
(22) Anmeldetag: 15.10.2002
(51) Int. Cl.: H01L 29/78, H01L 29/739, H01L 29/423, H01L 29/49

(54) **MIS-Halbleiteranordnungen mit einer Graben-Gateelektrode**

(30) Priorität: 23.11.2001 DE 10157510
(71) Anmelder: ROBERT BOSCH GMBH, 70442 Stuttgart (DE)
(72) Erfinder: Plikat, Robert, 71665 Vaihingen/Enz (DE); Feiler, Wolfgang, 72766 Reutlingen (DE)

(57) **Zusammenfassung**

Es wird eine Halbleiteranordnung (200,300) vorgeschlagen, die ein Grabengate (107) aufweist, wobei das Grabengate in vertikaler Richtung bis in den Substratbereich (102) reichend vorgesehen ist. Zudem kann das Grabengate in vertikaler Richtung von oben nach unten einen ersten Teilbereich (207a), einen zweiten Teilbereich (207b) und einen dritten Teilbereich (207c) umfassen, wobei der erste und der dritte Teilbereich eine höhere Leitfähigkeit aufweisen als der zweite Teilbereich.

## Beschreibung

### Stand der Technik

Es ist bekannt, Halbleiteranordnungen in Form von MOS-Halbleiterbauelementen (Metal Oxide Semiconductor) einzusetzen, wobei solche MOS-Halbleiterbauelemente insbesondere in der Leistungselektronik als Schaltelement weit verbreitet sind. Die Spannungsfestigkeit solcher MOS-Halbleiterbauelemente reicht von einigen Volt bis zu einigen Kilovolt und ihre Stromtragfähigkeit von einigen Hundert Ampere bis herab zu unter einem Ampere. Solche bekannten MOS-Schalter gestatten die Steuerung des durch sie fließenden Stromes mittels einer vom Strompfad galvanisch isolierten Steuerelektrode, dem sogenannten Gate. Bekannte Vertreter dieser Bauelementklasse sind z.B. der VMOS (Vertical-MOS-Transistor), der VIGBT (Vertical-Insulated-Gate-Bipolar-Transistor) und der Cool-MOS. Der Cool-MOS ist hierbei ein MOS-Transistor, in dessen Driftgebiet integral die gleiche Menge von Akzeptoren und Donatoren in einer Vielzahl jeweils aneinandergrenzender Bereiche eingebracht sind. Es handelt sich also um ein Ladungskompensationsbauelement. Bei den genannten MOS-Schaltern ist jeweils vorgesehen, dass der steuerbare Laststrom vorzugsweise vertikal durch das Halbleiterbauelement von einer ersten Elektrode zu einer zweiten Elektrode fließt, wobei die Elektroden auf der Oberund Unterseite des Halbleiterbauelements angeordnet sind. Die genannten Elektroden heißen Source und Drain beim VMOS und Cool-MOS sowie Kathode und Anode beim VIGBT. Weiterhin ist bekannt, bei solchen MOS-Halbleiterbauelementen das Gate, d.h. die Steuerelektrode als sogenanntes Grabengate (oder auch Trench-Gate) auszuführen, wobei die Gateelektrode mit samt des sie umgebenden isolierenden Gateoxids von beispielsweise der oberen Oberfläche des Halbleiterchips aus einige Mikrometer in die Tiefe des Bauelements hineinreicht.

### Vorteile der Erfindung

Die erfindungsgemäße Halbleiteranordnung mit den Merkmalen des Hauptanspruchs hat gegenüber den bekannten MOS-Halbleiterbauelementen den Vorteil, dass das erfindunsgemäße Grabengate bis zum Substratbereich des Halbleiterbauelements reicht. Dies hat den Vorteil, dass Durchlassverluste reduziert werden, die bei weniger tief ausgeführtem Grabengate zwangsläufig auftreten würden.

Durch die in den Unteransprüchen aufgeführten Maßnahmen sind vorteilhafte Weiterbildungen und Verbesserungen der im Hauptanspruch angegebenen Halbleiteranordnung möglich.

Besonders vorteilhaft ist, dass das Grabengate erfindungsgemäß keine Äquipotentialfläche darstellt. Es ist nämlich vorgesehen, dass in vertikaler Richtung des Grabengates von oben nach unten zunächst ein erster Teilbereich mit einer höheren Leitfähigkeit, danach ein zweiter Teilbereich mit einer geringeren Leitfähigkeit und weiterhin ein dritter Teilbereich mit einer wiederum erhöhten Leitfähigkeit vorgesehen ist. Dies hat den Vorteil, dass das Gateoxid, d.h. die Isolationsschicht zwischen dem Grabengate und dem zweiten und dritten Bereich durchgängig in einer Dicke ausgeführt werden kann. Weiterhin ist von Vorteil, dass dadurch Gebiete mit sehr hoher Feldstärkebelastung weitgehend vermieden werden und dadurch eine Schädigung der Isolationsschicht, d.h. des Gateoxids, beispielsweise durch Einlagerung von heißen Ladungsträgern ins Oxid, weitgehend vermieden wird, weil das Grabengate keine Äquipotentiallinie mit eckiger bzw. stark verrundeter Geometrie aufweist.

Die Maßnahme, dass das Grabengate die zuvor beschriebenen drei Teilbereiche aufweist und gleichzeitig bis zum ersten Bereich, d.h. dem Substratbereich in die Tiefe vordringt, hat weiterhin den Vorteil, dass der dritte Teilbereich des Grabengates in Kontakt zu dem ersten Bereich stehen kann, so dass beide galvanisch miteinander verbunden sind.

### Zeichnung

Ausführungsbeispiele der Erfindung sind in der Zeichnung dargestellt und in der nachfolgenden Beschreibung näher erläutert. Es zeigen
Figur 1 einen Ausschnitt aus einem herkömmlichen MOS-Bauelement mit Grabengate,
Figur 2 einen Ausschnitt aus einem herkömmlichen MOS-Bauelement mit vertieft vorgesehenem Grabengate,
Figur 3 eine erste Ausführungsform der erfindungsgemäßen Halbleiteranordnung und
Figur 4 eine zweite Ausführungsform der erfindungsgemäßen Halbleiteranordnung.

### Beschreibung der Ausführungsbeispiele

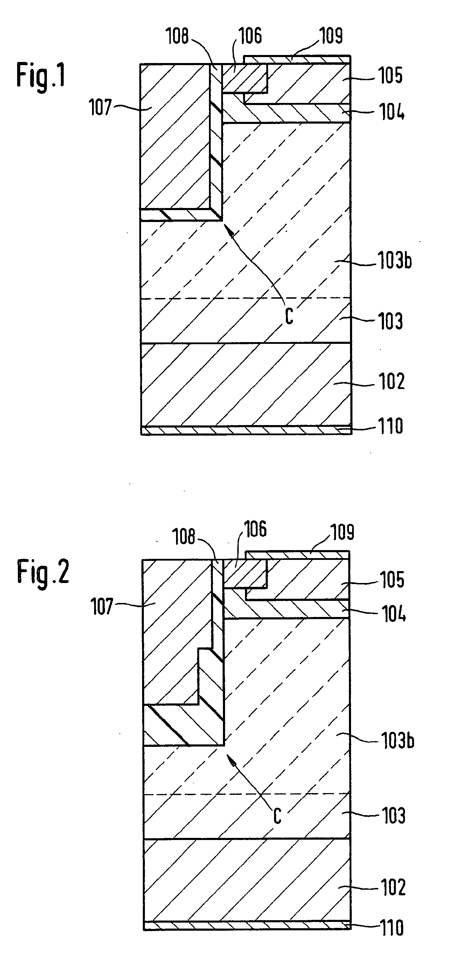

In Figur 1 ist ein Ausschnitt aus einem MOS-Halbleiterbauelement bekannter Art dargestellt. Der in Figur 1 und in allen weiteren Figuren dargestellte Teilbereich der Halbleiterbauelemente umfasst eine sogenannte Halbzelle, in Figur 1 die Halbzelle eines N-Kanal-VMOS-Halbleiterbauelements mit Trenchgate, d.h. mit Grabengate. In Figur 1 und in allen weiteren Figuren besteht das Gesamtbauelement erfindungsgemäß aus einer Vielzahl parallel geschalteter Zellen und ergibt sich durch mehrfaches Spiegeln der in den Figuren dargestellten Anordnungen an den Außenberandungen und durch Hinzufügen eines geeigneten Randabschlusses gemäß dem allgemeinen Stand der Technik.

In Figur 1 ist das Halbleiterbauelement auf einem hochdotieren n-Substrat vorgesehen, wobei das Substrat einen ersten Bereich 102 des Halbleiterbauelementes bildet. In vertikaler Richtung oberhalb des Substratbereichs 102 bzw. des ersten Bereichs 102 ist ein zweiter Bereich 103 vorgesehen, der als Driftgebiet dient. Der zweite Bereich 103 umfasst dabei eine Raumladungszone 103b, deren Ausdehnung abhängig davon ist, auf welchem Potential die mit dem Bezugszeichen 107 bezeichnete Grabenelektrode bzw. das Grabengate 107 und der erste Bereich 102 relativ zu einem vierten Bereicht 104 liegt, wobei der vierte Bereicht auch als p-Body-Gebiet 104 bezeichnet wird. Das Grabengate 107 ist in Figur 1 von allen anderen Bereichen des Halbleiterbauelements mittels einer Isolierschicht 108, dem sogenannten Gateoxid 108, isoliert. Insbesondere im Sperrfall des Halbleiterbauelementes, d.h., wenn der Widerstand des Bauelementes, gesteuert durch das Grabengate 107, hoch ist, bilden sich, insbesondere im Bereich einer mit einem Pfeil und dem Bezugszeichen C versehenden "Ecke" bzw. einer stark gekrümmten Rundung des Grabengates 107 Gebiete aus, die eine hohe Feldstärke von zum Teil einigen 100 kV/cm aufweisen.

Oberhalb des Driftgebietes 103 befindet sich bei dem in Figur 1 dargestellten Bauelement ein vierter Bereich 104 und ein fünfter Bereich 105, wobei der vierte Bereich 104 als Body-Gebiet und der fünfte Bereich 105 als p+-Kontaktdiffusion bezeichnet wird. Der vierte Bereich 104 weist ebenso wie der fünfte Bereich 105 eine Dotierung mit Akzeptoren auf, wobei der fünfte Bereich 105 eine größere Dotierstoffkonzentration als der vierte Bereich 104 aufweist. Oberhalb des vierten Bereichs 104 und seitlich neben dem fünften Bereich 105 befindet sich in Figur 1 ein stark mit Donatoren dotierter dritter Bereich 106, welcher auch als Source-Gebiet 106 bezeichnet wird. Das Source-Gebiet 106 ist mit einer Metallschicht 109, der sogenannten Source-Elektrode 109 verbunden, die dem elektrischen Anschluß des Halbleiterbauelements dient. Ebenso ist der erste Bereich 102 mit einer Metallschicht 110, der sogenannten Drain-Elektrode 110 versehen, welche die zweite Hauptelektrode des Bauelements darstellt. Das bereits erwähnte Grabengate 107, welches die Steuerelektrode des Bauelements darstellt, ist ebenfalls separat mit einer Metallschicht ansteuerbar, die jedoch in der Figur 1 und in den weiteren Figuren nicht dargestellt ist. Das Grabengate reicht in Figur 1 in vertikaler Richtung sowohl durch den dritten Bereich 106 als auch den vierten Bereich 104 als auch teilweise in das Driftgebiet bzw. den zweiten Bereich 103 hinein. Die Gateelektrode 107 ist, wie bereits erwähnt, an allen ihren Seiten zu anderen Bereichen des Halbleiterbauelements mittels der Isolierschicht 108 galvanisch getrennt.

In Figur 2 ist im Wesentlichen die gleiche Halbleiteranordnung wie in Figur 1 dargestellt. Der einzige Unterschied besteht darin, dass das Grabengate 107 in vertikaler Richtung weiter in den zweiten Bereich 103 eindringt als dies in Figur 1 dargestellt ist. Hierdurch entstünden an dem Eckbereich des Grabengates 107, welcher in Figur 2 ebenfalls mit einem Pfeil und dem Buchstaben C bezeichnet ist, noch höhere Feldstärken als an der vergleichbaren Stelle in Figur 1, so dass es bei der Halbleiteranordnung in Figur 2 vorgesehen ist, die Isolationsschicht 108 im Bereich des Gebiets C des Grabengates 107 mit einer größeren Dicke vorzusehen, um einen Oxiddurchbruch aufgrund der erhöhten Feldstärken am Punkt C bzw. in dessen Bereich zu vermeiden. Ansonsten entsprechen sich alle Bezugszeichen und die durch sie benannten Komponentengebiete und Teile in Figur 1 und Figur 2.

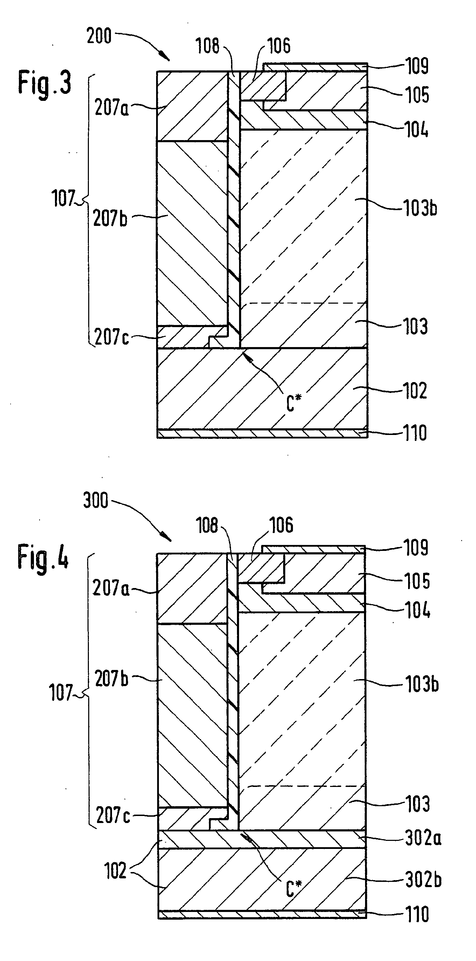

In Figur 3 ist eine erfindungsgemäße Halbleiteranordnung 200 dargestellt. Die erfindungsgemäße Halbleiteranordnung umfasst prinzipiell die gleichen Gebiete bzw. Bereiche die auch in den Figuren 1 und 2 dargestellt sind. So grenzt die Drainelektrodenmetallisierung 110 an den ersten Bereich 102 an, welcher die Substratschicht bzw. den Substratbereich der Halbleiteranordnung bezeichnet. Oberhalb des Substratbereichs 102 ist in vertikaler Richtung der zweite Bereich 103 vorgesehen, der wiederum die Raumladungszone 103b umfasst. Oberhalb des zweiten Bereichs 103 ist der vierte Bereich 104 angeordnet. Der erste Bereich 102 ist von einem ersten Ladungsträgertyp, im Beispiel vom negativen Ladungsträgertyp, d.h. er ist mit einem Dotierstoff in Form von Elektronendonatoren dotiert. Der erste Bereich 102 ist vergleichsweise hoch dotiert, z.B. mit 10¹⁹-10²⁰ Atomen/cm³. Der vierte Bereich 104 ist von einem zweiten Ladungsträgertyp, wobei der zweite Ladungsträgertyp von entgegengesetzter Ladung wie der erste Ladungsträgertyp ist. Im Beispiel entspricht dem zweiten Ladungsträgertyp eine Akzeptor-Dotierung. Oberhalb des vierten Bereichs 104 ist der dritte Bereich 106 seitlich neben dem Grabengate 107 angeordnet, wobei wiederum der dritte Bereich 106 vom ersten Ladungsträgertyp und zwar stark dotiert vorgesehen ist. Seitlich neben dem dritten Bereich 106 ist erfindungsgemäß der fünfte Bereich 105 vorgesehen, der bei hoher Dotierung vom zweiten Ladungsträgertyp, d.h. im Beispiel akzeptordotiert, vorgesehen ist. Oberhalb des dritten Bereichs 106 ist die Sourcemetallisierung 109, d.h. die Sourceelektrode 109 vorgesehen. Das Grabengate 107 umfasst erfindungsgemäß einen ersten Teilbereich 207a, einen zweiten Teilbereich 207b und einen dritten Teilbereich 207c. Hierbei weist der erste Teilbereich 207a und der dritte Teilbereich 207c eine höhere Leitfähigkeit auf als der zweite Teilbereich 207b. Typische maximale Dotierstoffkonzentrationen sind 10¹⁹-10²⁰ Atome/cm³ für die Bereiche 207a und 207c und 10¹²-10¹⁵ Atome/cm³ im Gebiet 207b ,bzw. vorzugsweise die Ausführung von 207b als SIPOS-Schicht (Semi-Insulating POlycristalline Silicon). Die Teilbereiche 207a bis 207c verlaufen in vertikaler Richtung von oben nach unten, wobei der erste Teilbereich 207a im oberen Bereich des Grabengates 107 etwa im Bereich seitlich neben dem zweiten Bereich 106 und des vierten Bereichs 104 vorgesehen ist. In vertikaler Richtung unter dem ersten Teilbereich 207a umfasst das Grabengate 107 den zweiten Teilbereich 207b und im Anschluß hieran wiederum darunter den Teilbereich 207c. Insgesamt verläuft das Grabengate 107 mit seinen drei Teilbereichen 207a-c durch den dritten Bereich 106 und den zweiten Bereich 103 hindurch, so dass das Grabengate 107 an den ersten Bereich 102 angrenzend vorgesehen ist. In einer besonders vorteilhaften Ausführungsform ist der dritte Teilbereich 207c mit dem ersten Bereich 102 bzw. dem Substrat 102 an seiner Unterseite galvanisch verbunden. Im Sperrfall der Halbleiteranordnung, d.h. wenn die Halbleiteranordnung zwischen den Elektroden 109, 110 einen vergleichsweise hohen Widerstand hat, weist das Grabengate in vertikaler Richtung einen Spannungsabfall auf, der in der gleichen Größenordnung wie der Spannungsunterschied zwischen diesen Elektroden 109, 110 liegt. Dies bringt es mit sich, dass das Grabengate gegenüber dem Stand der Technik wie er in der Figur 1 und 2 dargestellt ist, keine eckige bzw. stark gekrümmte Äquipotentialflächen mehr aufweist, was dazu führt, dass es keine Punkte gibt, die - insbesondere wie oben beschrieben an den Punkten c in den Figuren 1 und 2 - eine vergleichsweise hohe elektrische Feldstärke von einigen 100kV/cm mehr aufweisen, sondern vielmehr, dass der vertikale Potentialverlauf im Grabengate 107 in etwa dem entspricht, der im von der Raumladungszone 103b erfassten Driftgebiet 103 vorliegt. Durch die hohen Feldstärken an den Punkten C im in den Figuren 1 und 2 dargestellten Stand der Technik könnte es zu Oxidschädigungen durch Einlagerung von heißen Ladungsträgern ins Oxid und so zum Oxiddurchbruch, d.h. zum Durchbruch der Isolationsschicht 108, kommen. Demgegenüber ist in Figur 3 an einem Punkt C*, der durch einen Pfeil den unteren, an das zweite Gebiet 103 angrenzenden Teil des Grabengates 107 darstellt, mit geringeren elektrischen Feldstärken zu rechnen, so dass das Gateoxid 108 bzw. die Isolationsschicht 108 in diesem Bereich zwischen dem Grabengate 107 und dem zweiten Bereich 103 in gleicher Dicke vorgesehen ist, wie im ganzen Verlauf seiner vertikalen Ausdehnung. Eine Aufdickung der Isolationsschicht 108 bzw. des Gateoxids 108 ist bei der erfindungsgemäßen Halbleiteranordnung 200 nicht notwendig, was eine vereinfachte Herstellung derselben ermöglicht. Durch die in vertikaler Richtung vorgesehene Potentialverteilung im Grabengate 107 ist weiterhin der laterale Spannungsabfall zwischen dem Grabengate 107 und dem zweiten Bereich 103 über das dünne Gateoxid 108 verringert. Als Mittel hierfür ist, wie bereits beschrieben, der Teilbereich 207b des Grabengates 107 vorgesehen, der eine geringere Leitfähigkeit aufweist, beispielsweise mittels eines Materials SIPOS. Erfindungsgemäß ist es vorgesehen, die dritte Teilschicht 207c, welche eine höhere Leitfähigkeit als die zweite Teilschicht 207b aufweist, zum einen im Kontakt zum ersten Bereich 102 zu bringen, so dass sich eine galvanische Verbindung zwischen beiden einstellt, als auch vorzusehen, dass sich der dritte Teilbereich 207c mit der erhöhten Leitfähigkeit dadurch bildet, dass eine Ausdiffusion von Dotierstoff aus dem ersten Bereich 102 in den dritten Teilbereich 207c bei der Herstellung des Halbleiterbauelements 200 ergibt. Der Übergang zwischen den Teilschichten 207a bis 207c des Grabengates 107 kann fließend sein, wichtig ist jedoch, dass der erste Teilbereich 207a niederohmig genug ist, um ein gleichmäßiges Aufsteuern sämtlicher Zellen eines Halbleiterbauelements bei einer wohldefinierten Schwellspannung auch dann zu ermöglichen, wenn schnelle Gate-Ansteuersignale vorliegen. Weiterhin ist bei der Bereitstellung der Teilschichtenabfolge 207a bis 207c in dem Grabengate 107 darauf zu achten, dass die als Widerstand dienende zweite Teilschicht 207b hochohmig genug ist, um die nötige Gate-Ansteuerleistung klein zu halten, sowie laterale Spannungsabfälle in die erste Teilschicht 207a in einer Richtung, die in die Zeichenebene hineinweist, vernachlässigbar klein zu halten.

Die in Figur 3 beschriebene Halbleiteranordnung 200 ist erfindungsgemäß sowohl bei einem VMOS-Transistor als auch bei einem Cool-MOS-Transistor anwendbar. In beiden Fällen ist das Substrat 102 und die Teilbereiche 207a, 207c des Grabengates 107 für die beispielhaft betrachteten n-Kanal-Typen stark mit Donatoren dotiert, während das als Widerstand dienende Teilgebiet 207b des Grabengates niedrig mit Donatoren dotiert oder eine SIPOS-Schicht ist. Das Driftgebiet 103 weist im Falle des VMOS eine mittelstarke Donatordotierung auf, während im Falle des CoolMOS die integrale Dotierung aus Donatoren und Akzeptoren im Driftgebiet idealerweise null ist.

In Figur 4 ist ein zweites Ausführungsbeispiel der erfindungsgemäßen Halbleiteranordnung dargestellt. Das zweite Ausführungsbeispiel 300 der erfindungsgemäßen Halbleiteranordnung stellt einen n-Kanal-IGBT dar, wobei jedoch in Figur 4 wiederum nur eine Halbzelle 300 des zweiten Ausführungsbeispiels der erfindungsgemäßen Halbleiteranordnung dargestellt ist. Insbesondere ist die zweite Ausführungsform der erfindungsgemäßen Halbleiteranordnung 300 als Punch-Through-IGBT vorgesehen, welche mit einer n-Bufferschicht 302a und einer p⁺-Emitterschicht 302b vorgesehen ist. In diesem Fall wird also die n-Substratschicht 102, d.h. der erste Bereich 102 der erfindungsgemäßen Halbleiteranordnung gemäß dem zweiten Ausführungsbeispiel 300 ersetzt durch die p⁺-Emitterschicht 302b und die n-Bufferschicht 302a. Das Grabengate 107 reicht wiederum in vertikaler Richtung bis zur Bufferschicht 302a. Ansonsten ist die Schichtenabfolge identisch mit der in Figur 3 beschriebenen. Sämtliche Bezugszeichen und die durch sie bezeichneten Komponenten, Gebiete und Bereiche entsprechen einander.

Selbstverständlich sind die Bezeichnungen der Ladungsträgertypen in den einzelnen Bereichen nur beispielhaft zu sehen, so dass für nicht dargestellte P-Kanaltypen von Halbleiteranordnungen die Ladungsträgertypen jeweils umzukehren sind. Ebenso sind selbstverständlich die Polaritäten der anliegenden Spannungen sinngemäß zu wählen.

## Patentansprüche

1. Halbleiteranordnung (200) mit einem ersten Bereich (102) eines ersten Ladungsträgertyps, mit einem zweiten Bereich (103), der als Driftgebiet in vertikaler Richtung im Wesentlichen über dem ersten Bereich (102) vorgesehen ist, mit einem vierten Bereich (104) eines zweiten, dem ersten Ladungsträgertyp entgegengesetzten Ladungsträgertyps, der in vertikaler Richtung im Wesentlichen über dem zweiten Bereich (103) vorgesehen ist, mit einem dritten Bereich (106) des ersten Ladungsträgertyps, der in vertikaler Richtung im Wesentlichen über dem zweiten Bereich (103) vorgesehen ist und mit einem Grabengate (107), wobei eine Isolationsschicht (108) zwischen dem Grabengate (107) und sowohl dem zweiten Bereich (103) als auch dem dritten Bereich (106) vorgesehen ist, **dadurch gekennzeichnet, dass** das Grabengate (107) in vertikaler Richtung durch den zweiten Bereich (103), den vierten Bereich (104) und den dritten Bereich (106) durchreichend an den ersten Bereich (102) angrenzend vorgesehen ist.

2. Halbleiteranordnung (300) mit einem ersten Bereich (102), wobei der erste Bereich (102) eine Emitterschicht (302b) eines zweiten Ladungsträgertyps und eine darüber angeordnete Bufferschicht (302a) eines ersten, dem zweiten Ladungsträgertyp entgegengesetzten Ladungsträgertyps aufweist, mit einem zweiten Bereich (103), der als Driftgebiet in vertikaler Richtung im Wesentlichen über dem ersten Bereich (102) vorgesehen ist, mit einem vierten Bereich (104) eines zweiten Ladungsträgertyps, der in vertikaler Richtung im Wesentlichen über dem zweiten Bereich (103) vorgesehen ist, mit einem dritten Bereich (106) des ersten Ladungsträgertyps, der in vertikaler Richtung im Wesentlichen über dem zweiten Bereich (103) vorgesehen ist und mit einem Grabengate (107), wobei eine Isolationsschicht (108) zwischen dem Grabengate (107) und sowohl dem zweiten Bereich (103) als auch dem dritten Bereich (106) vorgesehen ist, **dadurch gekennzeichnet, dass** das Grabengate (107) in vertikaler Richtung durch den zweiten Bereich (103), den vierten Bereich (104) und den dritten Bereich (106) durchreichend an die Bufferschicht (302a) angrenzend vorgesehen ist oder in sie hineinreicht.

3. Halbleiteranordnung (200, 300) nach Anspruch 1 oder 2, **dadurch gekennzeichnet, dass** das Grabengate (107) in vertikaler Richtung von oben nach unten einen ersten Teilbereich (207a), einen zweiten Teilbereich (207b) und einen dritten Teilbereich (207c) umfasst, wobei der erste Teilbereich (207a) und der dritte Teilbereich (207c) eine höhere Leitfähigkeit aufweisen als der zweite Teilbereich (207b).

4. Halbleiteranordnung (200, 300) nach Anspruch 3, **dadurch gekennzeichnet, dass** der dritte Teilbereich (207c) in Kontakt mit dem ersten Bereich (102) steht.

5. Halbleiteranordnung (200, 300) nach Anspruch 2, 3 oder 4, **dadurch gekennzeichnet, dass** der dritte Teilbereich (207c) in Kontakt mit der Bufferschicht (302a) steht.

6. Halbleiteranordnung (200, 300) nach einem der vorhergehenden Ansprüche, **dadurch gekennzeichnet, dass** zumindest der zweite Teilbereich (207b) des Grabengates (107) aus einer semiisolierenden Schicht, insbesondere aus SIPOS (Semi-Insulating POlycristalline Silicon) besteht.

7. Halbleiteranordnung (200, 300) nach einem der Ansprüche 1 bis 6, **dadurch gekennzeichnet, dass** seitlich neben dem dritten Bereich (106) ein fünfter Bereich (105) vorgesehen ist, wobei der fünfte Bereich (105) von dem zweiten Ladungsträgertyp ist und wobei der fünfte Bereich (105) höher dotiert vorgesehen ist als der vierte Bereich (104).
